# EUROPEAN PATENT SPECIFICATION

(11) **EP 3 663 351 B1**
(45) Date of publication and mention of the grant of the patent: **23.08.2023**
(21) Application number: 17919885.8
(22) Date of filing: 19.10.2017
(51) Int. Cl.: C08L 25/16, C08L 9/00, C08F 212/12, C08F 212/36, B32B 15/085, H05K 1/03, C08J 5/24

(54) **THERMOSETTING RESIN COMPOSITION, AND PREPREG AND METAL FOIL CLAD LAMINATE PREPARED FROM SAME**
WÄRMEHÄRTENDE HARZZUSAMMENSETZUNG UND DARAUS HERGESTELLTES PREPREG UND METALLFOLIENBESCHICHTETES LAMINAT
COMPOSITION DE RÉSINE THERMODURCISSABLE ET STRATIFIÉ DE PRÉ-IMPRÉGNÉ ET DE REVÊTEMENT DE FEUILLE MÉTALLIQUE PRÉPARÉ À PARTIR DE CETTE COMPOSITION

(30) Priority: 04.08.2017 CN 201710661520
(43) Date of publication of application: 10.06.2020
(73) Proprietor: Shengyi Technology Co., Ltd., Dongguan City, Guangdong 523808 (CN)
(72) Inventor: GUAN, Chiji, Dongguan City Guangdong 523808 (CN); ZENG, Xianping, Dongguan City Guangdong 523808 (CN); CHEN, Guangbing, Dongguan City Guangdong 523808 (CN); XU, Haosheng, Dongguan City Guangdong 523808 (CN)
(74) Representative: Gill Jennings & Every LLP
(86) International application number: PCT/CN2017/106829
(87) International publication number: WO 2019/024254

(56) References cited:
- WO-A1-2017/115813
- CN-A- 1 914 239
- JP-A- 2006 070 136
- JP-A- 2006 089 683
- JP-A- 2006 274 169
- JP-A- 2007 262 191
- JP-A- 2008 248 001
- TW-A- 201 625 703
- US-A1- 2011 045 304
- HUBBARD K L ET AL: "Polymers with pendant vinyl groups, including poly(divinylbenzene-co-ethylvinylbenzene)" , REACTIVE AND FUNCTIONAL POLYMERS, ELSEVIER, AMSTERDAM, NL, vol. 36, no. 1, 1 February 1998 (1998-02-01), pages 1-16, XP004111441, ISSN: 1381-5148, DOI: 10.1016/S1381-5148(97)00126-0

## Description

### Technical field

The present invention belongs to the technical field of copper clad laminates, and relates to a thermosetting resin composition, a prepreg and a metal foil clad laminate prepared from the same.

### Background Art

With the development of high-performance, high-functionalization and networking of computers and information communication equipment, the operation signals tend to be high-frequency in recent years in order to transmit and process large-capacity information at high speed. Thus there is a demand for the material of circuit substrates. There has been rapid development, especially in those electronic devices that use broadband, such as mobile communication devices.

Among the current materials used for printed circuit boards, epoxy resins having excellent adhesion characteristics are widely used. However, the epoxy resin circuit board generally has a high dielectric constant and dielectric loss tangent (the dielectric constant Dk being greater than 4, dielectric loss tangent Df being about 0.02) and insufficient high frequency characteristics, so that it cannot meet the requirements of high frequency signal. Therefore, it is necessary to develop a resin excellent in dielectric properties, *i.e.* a resin having a low dielectric constant and a dielectric loss tangent. For a long time, those skilled in the art have studied thermosetting polyphenylene ether resins, bismaleimide resins, vinyl benzyl ether resins, hydrocarbon resins, etc., which have good dielectric properties. It is well known that the curable crosslinking hydrocarbon resin (polyolefin resin) has a low dielectric loss tangent Df (comparable to polytetrafluoroethylene resin), and has good fluidity, so as to attract a large number of in-depth studies by the majority of technicians. However, it cannot meet the process requirements of high-multilayer printed wiring boards due to its insufficient heat resistance, and it needs to be used together with other heat-resistant resins.

TW200536862A discloses that, in the organic solvent system, 20 to 100 mol.% of a divinyl aromatic compound and, if necessary, other monomers (such as ethyl vinyl aromatic compound, and other monomers) were added at a reaction temperature of 20 to 120°C in the presence of a Lewis acid catalyst and an initiator, and polymerized to prepare a soluble polyfunctional vinyl aromatic copolymer having a controlled molecular weight. The resin can be used in high friction fields related to electronic substrates and the like, and has good heat resistance and processability. Although the electronic circuit substrates prepared by using the copolymer have better dielectric properties and better heat resistance, it also has obvious defects of high brittleness. High brittleness has a large negative impact on subsequent PCB processing (serious wear of the drill, delamination of the sheet, and large halo after drilling, resulting in poor CAF), so that it cannot meet the requirements for the fabrication of high-multilayer printed circuit boards.

CN1914239A discloses copolymerization using a terminal vinyl-modified polyphenylene ether and a soluble polyfunctional vinyl aromatic copolymer to produce a copper clad laminate having excellent chemical resistance, dielectric properties and heat resistance. In order to improve the toughness of copper clad laminates, it is pointed out that one or two or more thermoplastic resins may be added, but the addition of a thermoplastic resin will greatly lower the glass transition temperature of the substrate. In addition, the thermoplastic resin and the cured product may be in compatible, resulting in phase separation of the substrate, greatly deteriorating the heat and humidity resistance of the substrate, and causing the high-multilayer printed circuit board to be delaminated after the heat treatment of the lead-free reflow soldering, so that it cannot be used.

CN103172803A discloses preparing an optical article having excellent optical properties such as refractive index and high light transmittance, heat resistance and processability after the composition containing the acryl-containing silicone resin and the initiator was cured by using a soluble polyfunctional copolymer. However, it is not disclosed that the resin composition can be used for a copper clad laminate and a prepreg. That is to say, after a copper clad laminate was prepared by curing the resin composition, the dielectric properties (dielectric loss tangent Df) thereof were remarkably deteriorated (the resin composition comprises the acryl-based organosilicon resin, and the acryl-containing organosilicon resin has a relatively higher polarity, so that it cannot meet the requirements of high-frequency signal transmission.

JP 2008/248001 discloses a curable resin composition which comprises component (A): a soluble polyfunctional vinyl aromatic copolymer; and component (B): a thermoplastic resin. The curable resin composition may further comprises (C) a thermosetting resin, (D) a flame retardant or (E) inorganic filler, etc. The composition may be used for printed circuit boards and laminates. Therefore, it is desirable in the art to obtain a resin composition which makes of copper clad laminates have good comprehensive properties of toughness, dielectric properties, and heat and humidity resistance.

### Summary of the Invention

Directed to the deficiencies of the prior art, it is an object of the present invention to provide a thermosetting resin composition, and a prepreg and a metal foil-clad laminate produced using the same.

To achieve this, the present invention uses the following technical solutions.

In one aspect, the present invention provides a thermosetting resin composition, wherein the thermosetting resin composition comprises
component (A) a solvent-soluble polyfunctional vinyl aromatic copolymer having a structural unit derived from monomers comprising divinyl aromatic compound (a) and ethyl vinyl aromatic compound (b), comprising 20 mol.% or more of repeating units derived from divinyl aromatic compound (a), wherein the molar fraction of the vinyl group-containing structural unit derived from the divinyl aromatic compound (a) represented by the following formulae (a1) and (a2) satisfies (a1)/[(a1)+(a2)]≥0.5; the polystyrene-equivalent number average molecular weight Mn measured by gel permeation chromatography is 600 to 30,000; and the ratio of the weight average molecular weight Mw to the number average molecular weight Mn is 20.0 or less, 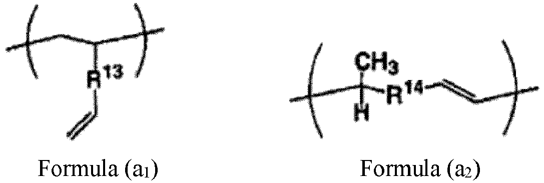 wherein R₁₃ represents an aromatic hydrocarbon group having 6 to 30 carbon atoms; R₁₄ represents an aromatic hydrocarbon group having 6 to 30 carbon atoms; and
component (B) which is selected from the group consisting of polybutadiene resins having a number average molecular weight of 500-10,000, the content of vinyl groups added at the 1,2 position in the molecular of the polybutadiene resins being 50% or more.

The resin component of the thermosetting resin composition of the present invention does not contain a polar hydroxyl group, and will not generate a polar group such as a secondary hydroxyl group during the curing process, thereby ensuring low water absorption of the circuit substrate and excellent dielectric properties. By using the polybutadiene resin as a crosslinking agent for a solvent-soluble polyfunctional vinyl aromatic copolymer, the resin composition has a high crosslinking density after curing, which remarkably improves the brittleness of the soluble polyfunctional vinyl aromatic copolymer. The circuit substrate prepared thereby has better toughness, improves the drilling processability of the PCB, and is beneficial to improving the reliability of the multilayer printed circuit board.

Preferably, in the thermosetting resin composition, the compounding amount of the component (A) is 10 to 98 wt.% (*e.g*. 10 wt.%, 15 wt.%, 20 wt.%, 25 wt.%, 28 wt.%, 30 wt.%, 35 wt.%, 38 wt.%, 40 wt.%, 50 wt.%, 60 wt.%, 70 wt.%, 80 wt.%, 90 wt.%, 95 wt.% or 98 wt.%), and the compounding amount of the component (B) is 2 to 90 wt.% (*e.g*. 2 wt.%, 5 wt.%, 8 wt.%, 10 wt.%, 15 wt.%, 20 wt.%, 25 wt.%, 30 wt.%, 40 wt.%, 50 wt.%, 60 wt.%, 70 wt.%, 80 wt.% or 90 wt.%), based on the total weight of the components (A) and (B). Preferably, the compounding amount of the component (A) is 30 to 90 wt.%, and the compounding amount of the component (B) is 10 to 70 wt.%.

In the thermosetting resin composition provided by the present invention, the component (A) is a soluble polyfunctional vinyl aromatic copolymer. In the copolymer, the main chain skeleton of the soluble polyfunctional vinyl aromatic copolymer has an indane structure represented by the following formula (a₃) 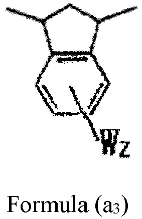 wherein W represents a saturated or unsaturated aliphatic hydrocarbon group or an aromatic hydrocarbon group, or an aromatic ring or a substituted aromatic ring fused to a benzene ring; Z is an integer of 0 to 4 *(e.g.* 0, 1, 2, 3, or 4).

Preferably, the component (A) is a soluble polyfunctional vinyl aromatic copolymer containing a structural unit of monovinyl aromatic compounds (c) other than the ethyl vinyl aromatic compounds (b).

The copolymer contains the structural units represented by the above (a₁), (a₂) and (a₃) as the repeating unit derived from the divinyl aromatic compound (a). In the structural units represented by the above (a₁), (a₂) and (a₃), R₁₃, R₁₄, W and Z have the same meanings as described above. But the proportion of each structural unit in the copolymer depends on the types of the divinyl aromatic compounds (a) and the ethylvinylaromatic compound (b), as well as the reaction conditions such as reaction catalyst, reaction temperature and the like.

In the present invention, the divinyl aromatic compound (a) used therein may be selected from the group consisting of, for example, m-divinylbenzene, p-divinylbenzene, 1,2-diisopropenylbenzene, 1,3-diisopropenylbenzene, 1,4-diisopropenylbenzene, 1,3-diisopropenylnaphthalene, 1,4-diisopropenylnaphthalene, 1,5-diisopropenylnaphthalene, 1,8-diisopropenylnaphthalene, 2,3-diisopropenylnaphthalene, 2,6-diisopropenylnaphthalene, 2,7-diisopropenylnaphthalene, 4,4'-divinylbiphenyl, 4,3'-divinylbiphenyl, 4,2'-divinylbiphenyl, 3,2'-divinylbiphenyl, 3,3'-divinylbiphenyl, 2,2'-divinylbiphenyl, 2,4-divinyl biphenyl, 1,2-divinyl-3,4-dimethylbenzene, 1,3-divinyl-4,5,8-tributylnaphthalene or 2,2'-divinyl- 4-ethyl-4'-propylbiphenyl, and a combination of at least two selected therefrom, but not limited to those as mentioned above. Moreover, those mentioned above may be used alone or in combination.

As a preferable specific example of the divinyl aromatic compound (a) to be used, divinylbenzene (both meta and para isomers), divinylbiphenyl (including each isomer) and divinylnaphthalene (including each isomer) are preferred in view of cost and heat resistance of the obtained polymers. More preferred are divinylbenzene (both meta and para isomers) and divinylbiphenyl (including individual isomers). In particular, divinylbenzene (both meta and para isomers) is most preferably used. Among the fields requiring higher heat resistance, divinylbiphenyl (including each isomer) and divinylnaphthalene (including each isomer) are particularly preferable.

In the polyfunctional vinyl aromatic copolymer, the ethyl vinyl aromatic compound used for providing the structural unit (b) for adjusting the compatibility to the vinyl organosilicon resin as component (B) and improving the solvent solubility and processability may be selected from the group consisting of o-ethylvinylbenzene, m-ethylvinylbenzene, p-ethylvinylbenzene, 2-vinyl-2'-ethylbiphenyl, 2-vinyl-3'-ethylbiphenyl, 2-vinyl-4'-ethylbiphenyl, 3-vinyl-2'-ethyl-biphenyl, 3-vinyl-3'-ethylbiphenyl, 3-vinyl-4'-ethylbiphenyl, 4-vinyl-2'-ethylbiphenyl, 4-vinyl-3'-ethylbiphenyl, 4-vinyl-4'-ethylbiphenyl, 1-vinyl-2-ethylnaphthalene, 1-vinyl-3-ethylnaphthalene, 1-vinyl-4-ethylnaphthalene, 1-vinyl-5-ethylnaphthalene, 1-vinyl-6-ethylnaphthalene, 1-vinyl-7-ethylnaphthalene, 1-vinyl-8-ethylnaphthalene, 2-vinyl-1-ethylnaphthalene, 2-vinyl-3-ethylnaphthalene, 2-vinyl- 4-ethylnaphthalene, 2-vinyl-5-ethylnaphthalene, 2-vinyl-6-ethylnaphthalene, 2-vinyl-7-ethylnaphthalene, 2-vinyl-8-ethylnaphthalene, but not limited to those as mentioned above. Moreover, those mentioned above may be used alone or in combination. The introduction of a structural unit derived from the component (b) into the polyfunctional vinyl aromatic copolymer not only can prevent gelation of the copolymer, but also can improve the solubility in a solvent. As a preferable specific example, ethyl vinylbenzene (both meta and para isomers) and ethyl vinylbiphenyl (including each isomer) may be exemplified in terms of cost, prevention of gelation, and heat resistance of the obtained cured product.

In order to improve the heat resistance of the cured product of the thermosetting resin composition of the present invention or to improve compatibility with other resins, a monovinyl aromatic compound (c) other than the added ethylvinyl aromatic compound (b) may be added. Preferred compounds is selected from styrene, styrene substituted with an alkyl group other than the ethyl vinyl aromatic compound, and aromatic vinyl compounds substituted with an alkyl group other than the ethyl vinyl aromatic compound, α-alkyl-substituted styrene, α-alkyl-substituted aromatic vinyl compounds, β-alkyl-substituted styrene, alkyl-substituted aromatic vinyl compounds, indene derivatives, acenaphthene derivatives and the like.

As the styrene substituted with an alkyl group on the ring, an alkyl-substituted styrene such as methyl styrene, ethyl styrene or butyl styrene can be used.

Further, styrene substituted with an alkyl group on the ring may be methoxystyrene, ethoxystyrene or butoxystyrene. Further, phenoxystyrene or the like can also be used.

As the aromatic vinyl compound, 2-vinylbiphenyl, 3-vinylbiphenyl, 4-vinylbiphenyl, 1-vinylnaphthalene or 1-vinylnaphthalene, for example, can be used.

As the aromatic vinyl compound substituted with an alkyl group on the ring, vinyl-propylbiphenyl or vinyl-propylnaphthalene, for example, can be used.

Further, as the α-alkyl substituted styrene, α-methylstyrene, α-ethylstyrene and the like can be used.

As the indene derivatives, in addition to indene, an alkyl-substituted indene such as methyl indene, ethyl indene, propyl indene or butyl indene may be used. Further, an alkoxy indene such as methoxy indene, ethoxy indene or butoxy indene can also be used.

As the acenaphthene derivatives, in addition to hydrazine, an alkyl-substituted acenaphthene such as methyl acenaphthene and ethyl acenaphthene may be used. Further, a halogenated acenaphthene such as chlorinated acenaphthene or brominated acenaphthene, as well as phenyl acenaphthene may be used.

For the soluble polyfunctional vinyl aromatic copolymer, these monovinyl aromatic compounds as the component (c) are not limited to these listed compounds. These substances may be used alone or in combination.

Among these monovinyl aromatic compounds as the component (c), styrene, α-alkyl-substituted styrene, α-alkyl-substituted aromatic vinyl compounds are preferred from the viewpoint of a large amount of indane structure formation in the skeleton of the polymer. As most preferable specific examples, styrene, α-methylstyrene, 4-isopropene and biphenyl are mentioned in terms of cost and heat resistance of the obtained polymer.

For the soluble polyfunctional vinyl aromatic copolymer, the divinyl aromatic compound as the component (a) is used in an amount of 20 to 99.5mol.% relative to the sum of the monomers composed of the component (a), the component (b) and the component (c), *e.g.* 20mol.%, 25mol.%, 28mol.%, 30mol.%, 35mol.%, 38mol.%, 40mol.%, 45mol.%, 50mol.%, 55mol.%, 60mol .%, 65mol.%, 70mol.%, 80mol.%, 90mol.%, 95mol% or 99mol.%, preferably 33 to 99mol.%, more preferably 45 to 95mol.%, particularly preferably 50 to 85mol.%. The content of the divinyl aromatic compound (a) of less than 20 mol.% will cause the heat resistance tends to be lowered, when the resulting soluble polyfunctional vinyl aromatic copolymer is cured, and thus is not preferable.

Further, for the soluble polyfunctional vinyl aromatic copolymer, the ethyl vinyl aromatic compound as the component (b) is used in an amount of 0.5 to 80mol.% relative to the sum of the monomers composed of the component (a), the component (b) and the component (c), *e.g.* 0.5mol.%, 0.8mol.%, 1mol.%, 5mol.%, 10mol.%, 15mol.%, 20mol.%, 25mol.%, 30mol.%, 35mol.%, 40mol.%, 45mol.%, 50mol.%, 55mol.%, 60mol.%, 65mol.%, 70mol.%, 75 or 80mol.%, preferably 1 to 70mol.%, more preferably 5 to 60mol.%, particularly preferably 15 to 50mol.%. The content of the ethyl vinyl aromatic compound (b) of higher than 70 mol.% will cause the heat resistance tends to be lowered, when the resulting soluble polyfunctional vinyl aromatic copolymer is cured, and thus is not preferable.

For the soluble polyfunctional vinyl aromatic copolymer, the monovinyl aromatic compound as the component (c) is used in an amount of less than 40mol.% relative to the sum of the monomers composed of the component (a), the component (b) and the component (c), *e.g.* 38mol.%, 35mol.%, 33mol.%, 30mol.%, 28mol.%, 25mol.%, 23mol.%, 20mol.%, 18mol.%, 15mol.%, 13mol.%, 10mol.%, 8mol.%, 5mol.%, 3 or 1mol.%, preferably less than 30mol.%, more preferably less than 25mol.%, particularly preferably less than 20mol.%. The content of the monovinyl aromatic compound (c) of higher than or equivalent to 40 mol.% will cause the heat resistance tends to be lowered, when the resulting soluble polyfunctional vinyl aromatic copolymer is cured, and thus is not preferable.

In the soluble polyfunctional vinyl aromatic copolymer, the mole fraction of the vinyl group-containing structural unit derived from the divinyl aromatic compound (a) represented by the above formulae (a₁) and (a₂) must satisfy (a₁)/[(a₁)+(a₂)]≥0.5, *e.g.* 0.5, 0.6, 0.7, 0.8, 0.9, 0.95, 0.98, preferably greater than or equal to 0.7, particularly preferably greater than or equal to 0.9. The mole fraction of less than 0.5 will cause the heat resistance of the cured product of the resulting copolymer is lowered, so as to take a longer curing time, and thus is not preferable.

Further, the main skeleton of the soluble polyfunctional vinyl aromatic copolymer must have an indane structure represented by the above formula (a₃). In the general formula (a₃), W has an unsaturated aliphatic hydrocarbon group such as vinyl group, an aromatic hydrocarbon group such as phenyl group. The substituents of these hydrocarbon groups may be substituted with 0 to 4 substituents. Further, W may also form a divalent hydrocarbon group such as a naphthalene ring by forming a condensed ring with a benzene ring of an indane structure, wherein the divalent hydrocarbon group may have a substituent.

The indane structure represented by the formula (a₃) is a structural unit which further improves the heat resistance of the soluble polyfunctional vinyl aromatic copolymer and solubility in a solvent, and is produced, under the conditions of a specific solvent, catalyst, temperature and the like while producing a polyfunctional vinyl aromatic group, by making the active site at the end of the growing polymer chain attack the aromatic ring in the structural unit derived from the divinyl aromatic compound and the monovinyl aromatic compound. Preferably, the indane structure is present in an amount of, based on the structural unit of the entire monomers, 0.01 mol.% or more, such as 0.01mol.%, 0.03mol.%, 0.05mol.%, 0.08mol.%, 0.1mol.%, 0.2mol,.%, 0.5mol.%, 0.8mol.%, 1mol.%, 1.3mol.%, 1.5mol.%, 1.8mol.%, 2mol.%, 5mol.%, 10mol.%, 15mol.%, 20mol.%, 25 or 30mol.%, more preferably 0.1mol% or more, further preferably 1mol% or more, particularly preferably 3mol% or more, and most preferably 5mol% or more. The upper limit is preferably 20mol.% or more, more preferably 15mol% or less. The main chain skeleton of the polyfunctional vinyl aromatic copolymer without the above-described indane structure will cause the heat resistance and solubility in a solvent are insufficient, and thus is not preferable.

The number average molecular weight Mn of the soluble polyfunctional vinyl aromatic copolymer (converted by using polystyrene measured by gel permeation chromatography) is preferably 600 to 30,000, *e.g.* 600, 800, 1000, 1500, 2000, 4000, 6000, 8000. , 10000, 15000, 20000, 25000 or 30,000, more preferably 600 to 10,000, most preferably 700 to 5,000. The Mn of less than 600 will cause it is difficult to glue or form a thick film since the viscosity of the soluble polyfunctional vinyl aromatic copolymer is too low, and workability is lowered, and thus is not preferable. Further, the Mn of more than 30,000 will cause the gel is easily produced to lower the compatibility with other resin components, and the appearance and physical properties are lowered in the case of sizing or film formation, and thus is not preferable.

Further, the value of the number average molecular weight distribution (M_{w}/Mₙ) of the soluble polyfunctional vinyl aromatic copolymer may be 20 or less, *e.g.* 20, 18, 15, 10, 8, 6, 4, 2, 1 and the like, preferably 15 or less, more preferably 10 or less, and most preferably 5 or less. If the M_{w}/Mₙ value exceeds 20, the viscosity of the thermosetting resin composition of the present invention increases, which deteriorates the processing properties, decreases the compatibility with other resin components, which is accompanied by a decrease in appearance and physical properties.

The soluble polyfunctional vinyl aromatic copolymer used as the component (A) has a metal ion content of preferably 500 ppm or less for each metal ion, *e.g.* 500ppm, 400ppm, 300ppm, 200ppm, 100ppm, 50ppm, 30ppm, 20ppm, 10ppm, 8ppm, 5ppm, 3ppm or 1ppm, more preferably 100ppm or less, further preferably 20ppm or less, and most preferably 1ppm or less.

The soluble polyfunctional vinyl aromatic copolymer may also be a substance obtained by copolymerization of trivinyl aromatic compounds, other divinyl compounds and monovinyl compounds, in addition to the above components (a), (b) and (c), without impairing the effects of the present invention.

Specific examples of the trivinyl aromatic compounds include, *e.g.* 1,2,4-trivinylbenzene, 1,3,5-trivinylbenzene, 1,2,4-triisopropylbenzene, 1,3,5-triisopropylbenzene, 1,3,5-trivinyl-naphthalene, 3,5,4'-trivinylbiphenyl and the like. Further, examples of other divinyl compounds include diene compounds such as butadiene and isoprene. Examples of the other monovinyl compounds include alkyl vinyl ether, aromatic vinyl ether, isobutylene and diisobutylene. These may be used alone or in combination. The amount of these other monomers used is less than 30 mol% based on the total amount of the monomers of the monovinyl aromatic compounds containing the divinyl aromatic compound components (a), (b) and (c).

The soluble polyfunctional vinyl aromatic copolymer can be obtained by, for example, polymerizing the monomer components containing the divinyl aromatic compound (a), the ethyl vinyl aromatic compound (b) and the monovinyl aromatic compound (c) other than the ethyl vinyl aromatic compound (b) in one or more organic solvents having a dielectric constant of 2 to 15, in the presence of the Lewis acid catalyst and the initiator having following formula (a₄), at a temperature of 20 to 100°C, 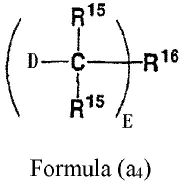 wherein R₁₅ represents a hydrogen atom or a monovalent hydrocarbon group having 1 to 6 carbon atoms; R₁₆ represents an E-valent aromatic hydrocarbon group or an aliphatic hydrocarbon group; D represents a halogen atom, an alkoxy group having 1 to 6 carbon atoms or an acyloxy group; E is an integer from 1 to 6. In the case where there are a plurality of R₁₅ and D in one molecule, they may be the same or different, respectively.

The method of recovering the copolymer after the polymerization reaction is stopped is not particularly limited. For example, a method generally used such as a stripping method or precipitation in a poor solvent can be used.

The component (B) of the thermosetting resin composition of the present invention is selected from polybutadiene resins having a number average molecular weight of 500 to 10,000 (*e.g.* 500, 800, 1,000, 3,000, 5,000, 8,000 or 10,000), and the content of vinyl groups added at the 1,2 position in the molecules thereof being greater than or equal to 50% (*e.g.* 50%, 55%, 60%, 65%, 70%, 75%, or 80% or more). Preferably, the polybutadiene resin has a number average molecular weight of from 1,000 to 8,000, more preferably from 1,500 to 6,000, most preferably from 2,000 to 5,000. If the molecular weight of the polybutadiene resin is too small, it is easily volatilized during the preparation of the prepreg, which is disadvantageous for stably producing the prepreg and the laminated sheet. If the molecular weight of the polybutadiene resin is too large (10,000 or more), it has a higher viscosity and is solid at normal temperature. It has a poor ability of dissolving in a solvent, so as to be difficult to form a uniform and stable resin composition, thereby be not advantageous to stably produce prepregs and laminated sheets. Even if prepregs are prepared, it is poor in fluidity due to the low viscosity of polybutadienes, therefore being difficult to meet the filling requirements of high-multilayer PCBs.

In addition, the molecular structure of the polybutadiene resin of the present invention has a certain content of vinyl groups added at the 1,2 position, which can be copolymerized with a polyfunctional vinyl aromatic copolymer to form a crosslinked network, providing good dielectric properties and effectively improving the brittleness of the polyfunctional vinyl aromatic copolymer caused by the self-curing. The polybutadiene resin has a content of vinyl groups added at the 1,2 position of not less than 50%, more preferably 70% or more, further preferably 90% or more. When the weight ratio of the butadiene group added at the 1,2 position in the molecule is less than 50%, it is difficult to provide sufficient unsaturated double bonds for the crosslinking reaction, resulting in low heat resistance of the cured product. The polybutadiene resin used may be selected from the group consisting of butadiene-styrene copolymer, styrene-isoprene copolymer, butadiene-styrene-divinylbenzene copolymer from STATTOMER, or a mixture selected therefrom.

Commercial products to choose from include, such as Ricon 100, Ricon 181, Ricon 184, Ricon 104, Ricon 104H, Ricon 250, R257 from SARTOMER, but are not limited to the products listed above.

The compounding ratio of the components (A) and (B) above for forming the thermosetting resin composition of the present invention may vary within a wide range, but the compounding amount (wt.%) of the components (A) and (B) must satisfy the following conditions: the compounding amount of the component (A) is 10 to 98 wt.%; and the compounding amount of the component (B) is 2 to 90 wt.%.

In the present invention, if the compounding amount of the component (B) is less than 2 wt.%, the toughness of the thermosetting resin composition after curing is poor; if it exceeds 90wt.%, the crosslinking density after curing of the thermosetting resin composition is insufficient, and the glass transition temperature is lowered. Since the polyfunctional vinyl aromatic copolymer and the polybutadiene resin used in the present invention have superior dielectric properties, a cured product excellent in dielectric properties can be formed.

In the thermosetting resin composition of the present invention, there further contains an initiator as the component (C) in addition to the components (A) and (B). Based on 100 parts by weight of the component (A) and the component (B), the component (C) is used in an amount of 0.1 to 10 parts by weight, e.g. 0.1, 0.5, 0.8, 1, 2, 3, 4, 5, 6, 7, 8, 9 or 10 parts by weight, preferably 0.5 to 8 parts by weight, further preferably 1 to 5 parts by weight.

In the present invention, the thermosetting resin composition contains an initiator as the component (C) for the purpose of improving the crosslinking curing effect. Although the polyfunctional vinyl aromatic copolymer and the vinyl organosilicon resin can also be cured under heating conditions, the introduction of the initiator can greatly improve the process efficiency and reduce the processing cost.

Preferably, the component (C) initiator has a half-life temperature t_{1/2} not less than 130°C; the initiator is a radical initiator.

Preferably, the initiator is selected from the group consisting of dicumyl peroxide, tert-butyl peroxybenzoate, 2,5-bis(2-ethylhexanoylperoxy)-2,5-dimethylhexane, di-(tert-butylperoxyisopropyl)benzene, 2,4-dichlorobenzoyl peroxide, 2,5-dimethyl-2,5-bis(tert-butylperoxy)hexane, tert-butyl-2-ethylhexyl peroxycarbonate, 2,5-dimethyl-2,5-bis(tert-butylperoxy)-3-hexyne, 4,4-di (tert-butyl-peroxy)butyl valerate, 1,1-bis(tert-butylperoxy)-3,3,5-trimethylcyclohexane, 3,3,5,7,7-pentamethyl-1,2,4-trioxepane, di-tert-butyl peroxide or t-butylperoxybenzene, or a combination of at least two selected therefrom.

In the resin composition of the present invention, the initiator as the component (C) may be used alone or in combination. To use in combination may achieve a better synergistic effect.

In the present invention, the thermosetting resin composition further comprises a filler, wherein the filler comprises an organic filler and/or an inorganic filler.

Preferably, the inorganic filler is selected from the group consisting of crystalline silica, fused silica, spherical silica, hollow silica, glass frit, aluminum nitride, boron nitride, silicon carbide, silicon aluminum silicate, hydrogen hydroxide aluminum, magnesium hydroxide, titanium dioxide, barium titanate, barium titanate, zinc oxide, zirconium oxide, aluminum oxide, barium oxide, magnesium oxide, barium sulfate, talc, clay, calcium silicate, calcium carbonate and mica, or a combination of at least two selected therefrom.

Preferably, the organic filler is selected from the group consisting of polytetrafluoroethylene powder, polyphenylene sulfide, polyetherimide, polyphenylene ether and polyethersulfone powder, or a combination of at least two selected therefrom.

Further, the present invention does not limit the shape and particle diameter of the inorganic filler.

The particle diameter generally used ranges from 0.01 to 50µm, e.g. 0.01µm, 0.05µm, 0.08µm, 0.1µm, 0.2µm, 0.5µm, 1µm, 3µm. , 5µm, 8µm, 10µm, 15µm, 20µm, 25µm, 30µm, 35µm, 40µm, 45µm or 50µm, preferably 0.01 to 20µm, more preferably 0.01 to 10µm, The inorganic filler within such particle size range is more easily dispersed in the resin liquid.

Further, the amount of the filler to be used in the thermosetting resin composition is not particularly limited. Based on 100 parts by weight of the component (A) component (B), the filler is preferably used in an amount of 5 to 400 parts by weight for example, e.g. 5, 10, 20, 30, 40, 50, 60, 70, 80, 90, 100, 110, 120, 130, 140 or 150, 200, 250, 300, 350 or 400 parts by weight, more preferably 5 to 200 parts by weight, further preferably 5 to 150 parts by weight.

Preferably, the thermosetting resin composition further comprises a flame retardant, wherein the flame retardant may be a bromine-containing flame retardant or a halogen-free flame retardant.

It is determined by the necessity of flame retardancy to comprise a flame retardant in the thermosetting resin composition of the present invention, so as to make the cured resin product have flame retardant properties and meet the requirements of UL 94 V-0. The flame retardant added as needed is not particularly limited, and it is preferred that the dielectric properties are not affected.

Preferably, the bromine-containing flame retardant is selected from the group consisting of decabromodiphenyl ether, decabromodiphenylethane, ethylene bistetrabromophthalimide and brominated polycarbonate, or a combination of at least two selected therefrom. The optional commercial bromine flame retardants are HT-93, HT-93W, HP-8010 or HP-3010, but are not limited to the above.

Preferably, the halogen-free flame retardant is selected from the group consisting of phosphorus-containing halogen-free flame retardants, nitrogen-containing halogen-free flame retardants and silicon-containing halogen-free flame retardants, or a combination of at least two selected therefrom;

Preferably, the halogen-free flame retardant is selected from the group consisting of tris(2,6-dimethylphenyl)phosphine, 10-(2,5-dihydroxyphenyl)-9,10-dihydro-9-oxa-10-phospha-phenanthrene-10-oxide, 2,6-bis(2,6-dimethylphenyl)phosphinobenzene and 10-phenyl-9,10-dihydro-9-oxa-10-phosphaphenanthrene-10-oxide, phenoxyphosphine cyanide compound, phosphate and polyphosphate, or a combination of at least two selected therefrom;

The optional commercial halogen-free flame retardants are SP-100, PK-200, PK-202, LR-202, LR-700, OP-930, OP-935 and LP-2200, but not limited to the above.

In the present invention, the amount of the flame retardant is determined according to the UL 94 V-0 level of the cured product, and is not particularly limited. In terms of heat resistance, dielectric properties, and hygroscopicity of the cured product, the flame retardant is used in an amount of 5 to 80 parts by weight, *e.g.* 5, 8, 10, 20, 30, 40, 50, 60, 70 or 80 parts by weight, preferably 10 to 60 parts by weight, more preferably 15 to 40 parts by weight, based on 100 parts by weight of the components (A)+(B). When the amount of flame retardant added is insufficient, a good flame retardant effect cannot be achieved; when the flame retardant is added in an amount of more than 80 parts by weight, there will be risks of lowered heat resistance and increased water absorption of the system. In addition, the dielectric performance of the system will also get worse.

Preferably, the thermosetting resin composition further comprises additives for solving some problems. The additives are selected form the group consisting of an antioxidant, a heat stabilizer, a light stabilizer, a plasticizer, a lubricant, a flow modifier, an anti-drip agent, an anti-blocking agent, an antistatic agent, a flow promoter, a processing aid, a substrate binder, a mold release agent, a toughening agent, a low shrinkage additive and a stress relief additive, or a combination of at least two selected therefrom.

In the thermosetting resin composition of the present invention, the amount of the additive is not particularly limited. Based on 100 parts by weight of the components (A)+(B), the amount of the additive is preferably 0.1 to 10 parts by weight, e.g. 0.1, 0.5, 0.8, 1, 2, 3, 4, 5, 6, 7, 8, 9 or 10 parts by weight, more preferably 0.5 to 8 parts by weight, further preferably 1 to 5 parts by weight.

In another aspect, the present invention provides a method for producing a thermosetting resin composition as described above, wherein the method comprising blending, stirring, and mixing by a known method with the soluble polyfunctional vinyl aromatic copolymer, polybutadiene resin, free radical initiator, powder filler, as well as various flame retardants and various additives.

In another aspect, the present invention provides a resin varnish obtained by dissolving or dispersing the thermosetting resin composition as described above in a solvent.

The solvent in the present invention is not particularly limited, and specific examples thereof include alcohols such as methanol, ethanol and butanol, ethers such as ethyl cellosolve, butyl cellosolve, ethylene glycol-methyl ether, carbitol and butyl carbitol, ketones such as acetone, butanone, methyl ethyl ketone, methyl isobutyl ketone and cyclohexanone, aromatic hydrocarbons such as toluene, xylene and mesitylene, esters such as ethoxyethyl acetate and ethyl acetate, nitrogen-containing solvents such as N,N-dimethylformamide, N,N-dimethylacetamide and N-methyl-2-pyrrolidone. These solvents may be used alone or in combination of two or more. Preferred are the combination of aromatic hydrocarbon solvents such as toluene, xylene, and mesitylene with acetone solvents, such as acetone, butanone, methyl ethyl ketone, methyl isobutyl ketone and cyclohexanone. The amount of the solvent to be used can be selected by those person skilled in the art according to his own experience, so that the obtained resin varnish can reach a viscosity suitable for use.

An emulsifier may be added during the process of dissolving or dispersing the resin composition as described above in a solvent. By dispersing by an emulsifier, the powder filler or the like can be uniformly dispersed in the glue.

In another aspect, the present invention provides a prepreg comprising a substrate and the thermosetting resin composition as described above adhered to the substrate by impregnation and drying.

The prepreg of the present invention may also be referred to as the prepreg, which may also be obtained by impregnating the substrate in the resin varnish as described above, and then heating and drying to remove the organic solvent and partially curing the resin composition in the substrate. The substrate described in the present invention may also be referred to as a reinforcing material.

Preferably, the substrate is a woven or nonwoven fabric made of organic fibers, carbon fibers or inorganic fibers.

Preferably, the organic fibers comprise aramid fibers such as Kevlar fibers from DuPont.

The woven fabric or the non-woven fabric obtained from the inorganic fibers is not particularly limited. Preferably, the woven fabric or non-woven fabric made from the inorganic fiber-made contains 50 to 99.9 wt.% (*e.g.* 50%, 55%, 58%, 60%, 65%, 70%, 75%, 80%, 85%, 88%, 90%, 95% or 99%) of SiO₂, 0-30 wt.% (*e.g.* 0%, 5%, 10%, 15%, 20%, 25% or 30%) of CaO, 0-20wt.% (*e.g.* 0%, 5%, 10%, 15% or 20%) of Al₂O₃, 0-25wt.% (e.g. 0%, 5%, 10%, 15%, 20% or 25%) of B₂O₃, and 0-5wt.% (*e.g*. 0%, 0.5%, 1%, 2%, 3%, 4% or 5%) of MgO, but is not limited to the above components. Preferably, the substrate (reinforcing material) is preferably a braided fiber cloth, optionally E-Glass, T-Glass, NE-Glass, L-Glass, Q-Glass, D-Glass, particularly preferably NE-Glass. The thickness of the substrate to be used is also not particularly limited.

The content of the resin used to impregnate the above substrate is preferably 30% by mass or more, such as 30% by mass, 35% by mass, 40% by mass, 50% by mass, 60% by mass or more, of the resin content in the prepreg. Since the dielectric constant of the substrate tends to be higher than that of the resin composition, the content of the resin composition component in the prepreg prefers the above content in order to lower the dielectric constant of the laminate obtained from these prepregs.

Preferably, the prepreg described above has a drying temperature of 80 to 200°C, such as 80°C, 90°C, 110°C, 120°C, 130°C, 140°C, 150°C, 170°C, 190°C or 200°C, a drying time of 1-30 min, e.g. 1 , 5 , 8, 13, 17 , 21 , 24 , 28 or 30 min.

In another aspect, the invention provides a laminate comprising at least one prepreg as described above.

In another aspect, the present invention provides a metal foil-clad laminate comprising one or at least two laminated prepregs as described above, and metal foil on one or both sides of the laminated prepregs.

Preferably, the metal foil is a copper foil. Preferably, the copper foil is an electrolytic copper foil or a rolled copper foil having a surface roughness of less than 5µm, *e.g.* 4, 3, 2, 1, 0.8, 0.5µm or the like. It can improve and increase the signal loss of laminate materials used in high frequency and high speed printed circuit boards.

Meanwhile, in order to improve the adhesion of one side of the copper foil prepreg, it is further preferred that the copper foil is chemically treated with a silane coupling agent selected from the group consisting of epoxy silane coupling agent, vinyl silane coupling agent and acrylate-based silane coupling agents, or a mixture of any two selected therefrom.

In another aspect, the present invention provides a high frequency high speed circuit board comprising one or at least two laminated prepregs as described above.

Specifically, the high speed circuit board of the present invention is produced by the following method:
overlapping at least one prepreg as described above, placing copper foils on the upper and lower sides of the prepreg, and lamination-molding. The overlapping is preferably an automated stacking operation to make the process operation easier.

The lamination-molding is preferably vacuum lamination-molding, and the vacuum lamination-molding can be carried out by a vacuum laminator. The lamination time is 70-120 min, such as 70, 75, 80, 85, 90, 95, 100, 105, 110, 115 or 120 min; the lamination temperature is 180-220°C, e.g. 180°C, 185°C, 190°C, 195°C, 200°C, 205°C, 210°C, 215°C or 220°C; the pressure of the lamination is 20-60 kg/cm², such as 20, 25, 30, 35, 40, 45, 50, 55, 58, 60 kg/cm².

The electronic circuit substrate prepared by the method of the invention has good toughness and maintains high glass transition temperature, low water absorption rate, excellent dielectric property and excellent heat and humidity resistance, and is very suitable for processing high-multilayer printed circuit boards.

In addition, in order to further improve the application of the materials in the high-frequency high-speed field, the copper foil used in the production of copper foil-clad laminates of the present invention may be selected from an electrolytic copper foil or a rolled copper foil, which has a surface roughness of less than 5 µm and can improve and increase the signal loss of the laminate material used in high-frequency high-speed printed circuit boards. At the same time, in order to improve the adhesion of one side of the copper foil prepreg, the copper foil can also be chemically treated with a silane coupling agent. The silane coupling agent is selected from the group consisting of epoxy silane coupling agent, vinyl silane coupling agent and acrylate-based silane coupling agent, or a mixture of more selected therefrom. The purpose is to provide a bonding force between the copper foil and the substrate to prevent the risk of dropped wire and pad during the use of the printed circuit board.

As compared with the prior art, the present invention has the following beneficial effects.

The polybutadiene resin is used as a crosslinking agent of the soluble polyfunctional vinyl aromatic copolymer, and the resin composition has a high crosslinking density after curing, and can provide a high glass transition temperature of the circuit substrate. The brittleness of the polyfunctional vinyl aromatic copolymer after curing is remarkably improved, and the prepared circuit substrate has better toughness to improve the drilling processability of the PCB, which is advantageous for improving the reliability of the multilayer printed circuit board. In addition, the polybutadiene resin containing vinyl group does not contain a polar group in the molecular structure, which ensures that the circuit board has low water absorption and excellent dielectric properties. In short, the prepreg and the copper-clad laminate prepared from the resin composition containing the polybutadiene resin and the soluble polyfunctional vinyl aromatic copolymer have good toughness and maintain high glass transition temperature, low water absorption, excellent dielectric properties and heat and humidity resistance, and are suitable for application in the field of high-frequency high-speed printed circuit boards and suitable for multi-layer printed circuit board processing.

### Examples

### Preparation Example 1

0.481 mol (68.4 mL) of divinylbenzene, 0.0362 mol (5.16 mL) of ethylvinylbenzene, 63 mL of a dichloroethane solution of 1-chlorovinylbenzene (40 mmol) (having a concentration of 0.634 mmol/mL), 11 mL of a dichloroethane solution of brominated tetra-n-butylammonium (1.5 mmol) (having a concentration of 0.135 mmol/mL), and 500 mL of dichloroethane were placed in a 1000 mL flask. 1.5 mL of a dichloroethane solution of 1.5 mmol SnCl₄ was added at 70°C (having a concentration of 0.068 mmol/mL), and the reaction lasts 1 hour. After the polymerization reaction of a small amount of methanol which was foamed with nitrogen, the reaction mixture was poured into a large amount of methanol at room temperature to precipitate a polymer. The obtained polymer was washed with methanol, filtered, dried, and weighed to obtain 54.6g of copolymer (49.8 wt.% yield)

The obtained polymer VOD-A had a Mw of 4,180, a Mn of 2560, and a Mw/Mn of 1.6. It was detected by using a JNM-LA600 type nuclear magnetic resonance spectroscopic device manufactured by JEOL that the polymer VOD-A was found to contain 52 mol.% of structural units derived from divinylbenzene and 48 mol.% of structural units derived from ethylvinylbenzene. Further, it is understood that there was an indane structure in the copolymer VOD-A. The indane structure was present in an amount of 7.5 mol.% relative to the structural units of all monomers. Moreover, the molar fraction of the structural unit represented by the formula (a₁) was 0.99 with respect to the total amount of the structural units represented by the above formulae (a₁) and (a₂).

The copolymer VOD-A was soluble in toluene, xylene, THF, dichloromethane, dichloroethane, chloroform, and no gel formation was observed.

### Preparation Example 2

0.481 mol (68 mL) of divinylbenzene, 0.362 mol (52 mL) of ethylvinylbenzene, 47 mL of a dichloroethane solution of 1-chlorovinylbenzene (30 mmol) (having a concentration of 0.634 mmol/mL), 65 mL of a dichloroethane solution of chlorinated tetra-n-butylammonium (2.25 mmol) (having a concentration of 0.035 mmol/mL), and 500 mL of dichloroethane were placed in a 1000 mL flask. 22 mL of a dichloroethane solution of 1.5 mmol SnCl₄ was added at 70°C (having a concentration of 0.068 mmol/mL), and the reaction lasts 1 hour. After the polymerization reaction of a small amount of methanol which was foamed with nitrogen, the reaction mixture was poured into a large amount of methanol at room temperature to precipitate a polymer. The obtained polymer was washed with methanol, filtered, dried, and weighed to obtain 67.4g of copolymer VOD-B (61.4 wt.% yield)

The obtained polymer VOD-B had a Mw of 7,670, a Mn of 3680, and a Mw/Mn of 2.1. It was detected by using a JNM-LA600 type nuclear magnetic resonance spectroscopic device manufactured by JEOL that the polymer VOD-B was found to contain 51 mol.% of structural units derived from divinylbenzene and 49 mol.% of structural units derived from ethylvinylbenzene. Further, it is understood that there was an indane structure in the copolymer VOD-B. The indane structure was present in an amount of 7.5 mol.% relative to the structural units of all monomers. Moreover, the molar fraction of the structural unit represented by the formula (a₁) was 0.99 with respect to the total amount of the structural units represented by the above formulae (a₁) and (a₂).

The copolymer VOD-B was soluble in toluene, xylene, THF, dichloromethane, dichloroethane, chloroform, and no gel formation was observed.

### Preparation Example 3

0.0481 mol (6.84 mL) of divinylbenzene, 0.0362 mol (5.16 mL) of ethylvinylbenzene, 12.0mg of a cobalt chain transferring agent having the following formula (a₅) 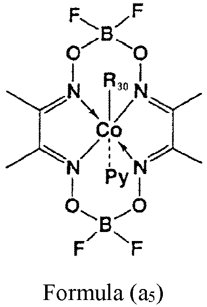 (wherein R₃₀ is an isopropyl group; Py is pyridyl group) and 150ml of tetrahydrofuran were placed in a 300 ml flask, then 2,2'-azobis(2,4-dimethylvaleronitrile) was added at 50°C, and reacted for 72 hours. The reaction mixture was poured into a large amount of methanol at room temperature to precipitate a polymer. The obtained polymer was washed with methanol, filtered, dried, and weighed to obtain 3.15g of copolymer VOD-C (28.7 wt.% yield)

The obtained polymer VOD-c contained Gel, so it is soluble only in THF solvent. It had a Mw of 94,600, a Mn of 12,800, and a Mw/Mn of 7.4. It was detected by using a JNM-LA600 type nuclear magnetic resonance spectroscopic device manufactured by JEOL that the polymer VOD-C was found to contain 58 mol.% of structural units derived from divinylbenzene and 42 mol.% of structural units derived from ethylvinylbenzene. Further, it is understood that there was no indane structure in the copolymer VOD-C. Moreover, the molar fraction of the structural unit represented by the formula (a₁) was 0.25 with respect to the total amount of the structural units represented by the above formulae (a₁) and (a₂).

**Table 1 Materials in the examples and comparison examples**

| Manufacturer | Product name or brand | Material description |
|---|---|---|
| Self-made | Copolymer VOD-A | Polyfunctional vinyl aromatic copolymer |
| Self-made | Copolymer VOD-B | Polyfunctional vinyl aromatic copolymer |
| Self-made | Copolymer VOD-C | Polyfunctional vinyl aromatic copolymer |
| Sartomer | Ricon 130 | Polybutadiene having a low vinyl content (having a molecular weight of about 2,500 and 1,2-vinyl content of 28%) |
| Sartomer | Ricon 142 | Polybutadiene having a medium vinyl content (having a molecular weight of about 3,900 and 1,2-vinyl content of 55%) |
| Sartomer | Ricon 154 | Polybutadiene having a high vinyl content (having a molecular weight of about 1,400 and 1,2-vinyl content of 70%) |
| Sartomer | Ricon 153 | Polybutadiene having a high vinyl content (having a molecular weight of about 5,200 and 1,2-vinyl content of 90%) |
| Nippon Soda | B-1000 | Polybutadiene having a high vinyl content (having a molecular weight of about 1,200 and 1,2-vinyl content of higher than 85%) |
| Nippon Soda | B-3000 | Polybutadiene having a high vinyl content (having a molecular weight of about 3,200 and 1,2-vinyl content of higher than 90%) |
| Nippon Soda | GI-3000 | Hydroxyl-terminated polybutadiene (having a molecular weight of about 3,100 and containing no 1,2-vinyl) |
| Albemarle | BT-93 W | Ethylene bis-tetrabromophthalimide |
| Mitsubishi Gas | OPE-2ST-1 | Vinyl modified polyphenylene ether resin |
| Asahi Kasei | H1041 | Hydrogenated styrene butadiene block copolymer |
| Xinqiao Chemical | DCP | Dicumyl peroxide |
| Admatechs | S0-C2 | D50: 0.5um spherical silicon |
| Nittobo | 2116NE | NE-glass fiberglass cloth |

### Example 1

80.0 parts by weight of the polyfunctional vinyl aromatic copolymer VOD-A, 20.0 parts by weight of polybutadiene Ricon 142 (from Sartomer) having a medium vinyl content, 3.0 parts by weight of a radical initiator DCP, 25 parts by weight of a bromine flame retardant BT-93W, and 60 parts by weight of the silica fine powder S0-C2 were dissolved in a toluene solvent, and adjusted to a suitable viscosity. NE-glass fiber cloth (Nittobo, model 2116NE) was impregnated with the resin varnish, controlled to be suitable for piece weight by a clamping axis, and dried in an oven to remove the toluene solvent, so as to prepare a 2116 prepreg. 6 sheets of 2116 prepregs and 12 sheets of 2116 prepregs were respectively overlapped, and were coated with a copper foil having a thickness of 1OZ on both the upper and lower sides, vacuum laminated and cured for 120 min in a press at a curing pressure of 50 kg/cm², and a curing temperature of 200°C, to prepare high-speed circuit boards with two thickness specifications (6*2116-0.76mm plates for testing comprehensive performance, 12*2116-1.52mm thick plates for testing mechanical properties). The physical properties of the prepared copper foil substrate were tested, and the results are shown in Table 2 in detail.

### Example 2

It was the same as in the process of Example 1, except for that the polybutadiene resin was replaced by polybutadiene Ricon 154 having a high vinyl content. The physical properties of the prepared copper foil substrate were tested, and the results are shown in Table 2 in detail.

### Example 3

It was the same as in the process of Example 1, except for that the polybutadiene resin was replaced by polybutadiene Ricon 153 having a high vinyl content. The physical properties of the prepared copper foil substrate were tested, and the results are shown in Table 2 in detail.

### Example 4

It was the same as in the process of Example 1, except for that the polybutadiene resin was replaced by polybutadiene B-1000 having a high vinyl content. The physical properties of the prepared copper foil substrate were tested, and the results are shown in Table 2 in detail.

### Example 5

It was the same as in the process of Example 1, except for that the polybutadiene resin was replaced by polybutadiene B-3000 having a high vinyl content. The physical properties of the prepared copper foil substrate were tested, and the results are shown in Table 2 in detail.

### Example 6

It was the same as in the process of Example 1, except for that the ratio of the polyfunctional vinyl aromatic copolymer VOD-A and polybutadiene B-3000 having a high vinyl content had changed from the original weight ratio of 80:20 to 50:50. The physical properties of the prepared copper foil substrate were tested, and the results are shown in Table 2 in detail.

### Example 7

It was the same as in the process of Example 6, except for that the ratio of the polyfunctional vinyl aromatic copolymer VOD-A and polybutadiene B-3000 having a high vinyl content had changed from the original weight ratio of 80:20 to 13:87 The physical properties of the prepared copper foil substrate were tested, and the results are shown in Table 2 in detail.

### Example 8

It was the same as in the process of Example 6, except for that the ratio of the polyfunctional vinyl aromatic copolymer VOD-A and polybutadiene B-3000 having a high vinyl content had changed from the original weight ratio of 80:20 to 93:7 The physical properties of the prepared copper foil substrate were tested, and the results are shown in Table 2 in detail.

### Example 9

It was the same as in the process of Example 1, except for that the polyfunctional vinyl aromatic copolymer VOD-A was replaced with the polyfunctional vinyl aromatic copolymer VOD-B. The physical properties of the prepared copper foil substrate were tested, and the results are shown in Table 2 in detail.

### Comparison Example 1

100 parts by weight of the polyfunctional vinyl aromatic copolymer VOD-A, 3.0 parts by weight of a radical initiator DCP, 25 parts by weight of a bromine flame retardant BT-93W, and 60 parts by weight of the silica fine powder S0-C2 were dissolved in a toluene solvent, and adjusted to a suitable viscosity. NE-glass fiber cloth (Nittobo, model 2116NE) was impregnated with the resin varnish, controlled to be suitable for piece weight by a clamping axis, and dried in an oven to remove the toluene solvent, so as to prepare a 2116 prepreg. 6 sheets of 2116 prepregs and 12 sheets of 2116 prepregs were respectively overlapped, and were coated with a copper foil having a thickness of 1OZ on both the upper and lower sides, vacuum laminated and cured for 120 min in a press at a curing pressure of 50 kg/cm², and a curing temperature of 200°C, to prepare high-speed circuit boards with two thickness specifications (6*2116-0.76mm plates for testing comprehensive performance, 12*2116-1.52mm thick plates for testing mechanical properties). The physical properties of the prepared copper foil substrate were tested, and the results are shown in Table 3 in detail.

### Comparison Example 2

80.0 parts by weight of the polyfunctional vinyl aromatic copolymer VOD-A, 20.0 parts by weight of polybutadiene Ricon 154 (Sartomer) having a high vinyl content, 3.0 parts by weight of a radical initiator DCP, 25 parts by weight of a bromine flame retardant BT-93W, and 60 parts by weight of the silica fine powder S0-C2 were dissolved in a toluene solvent, and adjusted to a suitable viscosity. NE-glass fiber cloth (Nittobo, model 2116NE) was impregnated with the resin varnish, controlled to be suitable for piece weight by a clamping axis, and dried in an oven to remove the toluene solvent, so as to prepare a 2116 prepreg. 6 sheets of 2116 prepregs and 12 sheets of 2116 prepregs were respectively overlapped, and were coated with a copper foil having a thickness of 1OZ on both the upper and lower sides, vacuum laminated and cured for 120 min in a press at a curing pressure of 50 kg/cm², and a curing temperature of 200°C, to prepare high-speed circuit boards with two thickness specifications (6*2116-0.76mm plates for testing comprehensive performance, 12*2116-1.52mm thick plates for testing mechanical properties). The physical properties of the prepared copper foil substrate were tested, and the results are shown in Table 3 in detail.

### Comparison Example 3

48 parts by weight of the polyfunctional vinyl aromatic copolymer VOD-A, 12 parts by weight of vinyl modified polyphenylene ether resin OPE-2ST-1, 40 parts by weight of hydrogenated styrene butadiene block copolymer H1041, 3.0 parts by weight of a radical initiator DCP, 25 parts by weight of a bromine flame retardant BT-93W, and 60 parts by weight of the silica fine powder S0-C2 were dissolved in a toluene solvent, and adjusted to a suitable viscosity. NE-glass fiber cloth (Nittobo, model 2116NE) was impregnated with the resin varnish, controlled to be suitable for piece weight by a clamping axis, and dried in an oven to remove the toluene solvent, so as to prepare a 2116 prepreg. 6 sheets of 2116 prepregs and 12 sheets of 2116 prepregs were respectively overlapped, and were coated with a copper foil having a thickness of 1OZ on both the upper and lower sides, vacuum laminated and cured for 120 min in a press at a curing pressure of 50 kg/cm², and a curing temperature of 200°C, to prepare high-speed circuit boards with two thickness specifications (6*2116-0.76mm plates for testing comprehensive performance, 12*2116-1.52mm thick plates for testing mechanical properties). The physical properties of the prepared copper foil substrate were tested, and the results are shown in Table 3 in detail.

### Comparison Example 4

80.0 parts by weight of the polyfunctional vinyl aromatic copolymer VOD-A, 20 parts by weight of methyl-terminated acryloyl cage silsesquioxane A, 3.0 parts by weight of a radical initiator DCP, 25 parts by weight of a bromine flame retardant BT-93W, and 60 parts by weight of the silica fine powder S0-C2 were dissolved in a toluene solvent, and adjusted to a suitable viscosity. NE-glass fiber cloth (Nittobo, model 2116NE) was impregnated with the resin varnish, controlled to be suitable for piece weight by a clamping axis, and dried in an oven to remove the toluene solvent, so as to prepare a 2116 prepreg. 6 sheets of 2116 prepregs and 12 sheets of 2116 prepregs were respectively overlapped, and were coated with a copper foil having a thickness of 1OZ on both the upper and lower sides, vacuum laminated and cured for 120 min in a press at a curing pressure of 50 kg/cm², and a curing temperature of 200°C, to prepare high-speed circuit boards with two thickness specifications (6*2116-0.76mm plates for testing comprehensive performance, 12*2116-1.52mm thick plates for testing mechanical properties). The physical properties of the prepared copper foil substrate were tested, and the results are shown in Table 3 in detail.

### Comparison Example 5

80.0 parts by weight of the polyfunctional vinyl aromatic copolymer VOD-A, 20.0 parts by weight of polybutadiene Ricon 130 (Sartomer) having a low vinyl content, 3.0 parts by weight of a radical initiator DCP, 25 parts by weight of a bromine flame retardant BT-93W, and 60 parts by weight of the silica fine powder S0-C2 were dissolved in a toluene solvent, and adjusted to a suitable viscosity. NE-glass fiber cloth (Nittobo, model 2116NE) was impregnated with the resin varnish, controlled to be suitable for piece weight by a clamping axis, and dried in an oven to remove the toluene solvent, so as to prepare a 2116 prepreg. 6 sheets of 2116 prepregs and 12 sheets of 2116 prepregs were respectively overlapped, and were coated with a copper foil having a thickness of 1OZ on both the upper and lower sides, vacuum laminated and cured for 120 min in a press at a curing pressure of 50 kg/cm², and a curing temperature of 200°C, to prepare high-speed circuit boards with two thickness specifications (6*2116-0.76mm plates for testing comprehensive performance, 12*2116-1.52mm thick plates for testing mechanical properties). The physical properties of the prepared copper foil substrate were tested, and the results are shown in Table 3 in detail.

### Comparison Example 6

80.0 parts by weight of the polyfunctional vinyl aromatic copolymer VOD-A, 20 parts by weight of the hydroxyl-terminated polybutadiene resin GI-3000 (Nippon Soda), 3.0 parts by weight of a radical initiator DCP, 25 parts by weight of a bromine flame retardant BT-93W, and 60 parts by weight of the silica fine powder S0-C2 were dissolved in a toluene solvent, and adjusted to a suitable viscosity. NE-glass fiber cloth (Nittobo, model 2116NE) was impregnated with the resin varnish, controlled to be suitable for piece weight by a clamping axis, and dried in an oven to remove the toluene solvent, so as to prepare a 2116 prepreg. 6 sheets of 2116 prepregs and 12 sheets of 2116 prepregs were respectively overlapped, and were coated with a copper foil having a thickness of 1OZ on both the upper and lower sides, vacuum laminated and cured for 120 min in a press at a curing pressure of 50 kg/cm², and a curing temperature of 200°C, to prepare high-speed circuit boards with two thickness specifications (6*2116-0.76mm plates for testing comprehensive performance, 12*2116-1.52mm thick plates for testing mechanical properties). The physical properties of the prepared copper foil substrate were tested, and the results are shown in Table 3 in detail.

**Table 2**

| Materials and performances | Example 1 | Example 2 | Example 3 | Example 4 | Example 5 | Example 6 | Example 7 | Example 8 | Example 9 |
|---|---|---|---|---|---|---|---|---|---|
| Copolymer VOD-A | 80 | 80 | 80 | 80 | 80 | 50 | 13 | 93 | |
| Copolymer VOD-B | | | | | | | | | 80 |
| Copolymer VOD-C | | | | | | | | | |
| Ricon 130 | | | | | | | | | |
| Ricon 142 | 20 | | | | | | | | |
| Ricon 154 | | 20 | | | | | | | |
| Ricon 153 | | | 20 | | | | | | |
| B-1000 | | | | 20 | | | | | |
| B-3000 | | | | | 20 | 50 | 87 | 7 | 20 |
| GI-3000 | | | | | | | | | |
| OPE-2ST-1 | | | | | | | | | |
| H1041 | | | | | | | | | |
| Cage silsesquioxane A | | | | | | | | | |
| DCP | 3.0 | 3.0 | 3.0 | 3.0 | 3.0 | 3.0 | 3.0 | 3.0 | 3.0 |
| BT-93 W | 25 | 25 | 25 | 25 | 25 | 25 | 25 | 25 | 25 |
| S0-C2 | 60 | 60 | 60 | 60 | 60 | 60 | 60 | 60 | 60 |
| Tg-DMA(°C) | 260.6 | 283.3 | 290.2 | 286.1 | 292.0 | 272.2 | 212.2 | 292.6 | 291.2 |
| Td-5%loss (°C) | 416.2 | 415.3 | 416.3 | 413.2 | 416.3 | 417.3 | 416.5 | 414.2 | 413.5 |
| PCT water absorption rate (%) | 0.15 | 0.15 | 0.14 | 0.14 | 0.14 | 0.15 | 0.15 | 0.14 | 0.14 |
| Dielectric constant (10GHz) | 3.41 | 3.40 | 3.41 | 3.40 | 3.41 | 3.40 | 3.41 | 3.40 | 3.40 |
| Dielectric loss factor (10GHz) | 0.0021 | 0.0020 | 0.0020 | 0.0020 | 0.0021 | 0.0020 | 0.0020 | 0.0020 | 0.0020 |
| Pendulum Impact strength (kJ/m²) | 65.368 | 64.589 | 64.201 | 65.365 | 64.201 | 65.365 | 66.135 | 62.451 | 64.547 |
| Drop hammer impact toughness | ⊚ | ⊚ | ⊚ | ⊚ | ⊚ | ⊚ | ⊚ | ⊚ | ⊚ |
| PCT | >300s | >300s | >300s | >300s | >300s | >300s | >300s | >300s | >300s |

**Table 3**

| Materials and performances | Comp. Example 1 | Comp. Example 2 | Comp. Example 3 | Comp. Example 4 | Comp. Example 5 | Comp. Example 6 |
|---|---|---|---|---|---|---|
| Copolymer VOD-A | 100 | | 48 | 80 | 80 | 80 |
| Copolymer VOD-B | | | | | | |
| Copolymer VOD-C | | 80 | | | | |
| Ricon 130 | | | | | 20 | |
| Ricon 142 | | | | | | |
| Ricon 154 | | 20 | | | | |
| Ricon 153 | | | | | | |
| B-1000 | | | | | | |
| B-3000 | | | | | | |
| GI-3000 | | | | | | 20 |
| OPE-2ST-1 | | | 12 | | | |
| H1041 | | | 40 | | | |
| Cage silsesquioxane A | | | | 20 | | |
| DCP | 3.0 | 3.0 | 3.0 | 3.0 | 3.0 | 3.0 |
| BT-93W | 25 | 25 | 25 | 25 | 25 | 25 |
| S0-C2 | 60 | 60 | 60 | 60 | 60 | 60 |
| Tg-DMA(°C) | 291.6 | 211.2 | 202.6 | 289.3 | 246.3 | 203.4 |
| Td-5%loss (°C) | 416.2 | 360.2 | 412.3 | 414.2 | 412.6 | 414.3 |
| PCT water absorption rate (%) | 0.14 | 0.15 | 0.25 | 0.15 | 0.16 | 0.23 |
| Dielectric constant (10GHz) | 3.40 | 3.40 | 3.43 | 3.55 | 3.40 | 3.80 |
| Dielectric loss factor (10GHz) | 0.0020 | 0.0020 | 0.0030 | 0.0050 | 0.0020 | 0.0052 |
| Pendulum Impact strength (kJ/m²) | 45.687 | 58.234 | 55.501 | 54.632 | 65.547 | 50.321 |
| Drop hammer impact toughness | △ | ○ | ○ | ○ | ⊚ | ○ |
| PCT | >300s | 10s; delamination | 2s; delamination | >300s | >300s | 3s; delamination |

The test methods for the above characteristics are as follows.
1) Glass transition temperature (Tg): The Tg of the laminate was measured according to the dynamic thermal mechanical analysis (DMA) method specified in IPC-TM-650 2.4.24.4.
2) Thermal decomposition temperature (Td-5% loss): According to the thermogravimetric analysis (TGA), the temperature Td at 5% weight loss of the laminate was measured according to the TGA method specified in IPC-TM-650 2.4.24.6.
3) PCT water absorption rate: After etching the copper foil on the surface of the copper clad laminate, the substrate was dried to weigh the original weight, and then placed in a pressure cooker, treated at 120°C and 150 KPa for two hours, taken out with a dry cloth, wiped to dry and to weigh the sample after water absorption. PCT water absorption (weight after cooking-weight before cooking)/weight before cooking.
4) Dielectric constant Dk and dielectric loss factor Df: Tested according to the SPDR (Split Post Dielectric Resonator) method at a test frequency of 10 GHz.
5) Pendulum impact strength: Using a simple-supported beam non-metallic material pendulum impact tester. A laminate of about 1.6 mm was made into several 120 mm* 10 mm notched samples (notch depth 2 mm). The pendulum was used to impact the sample at a speed of 3.8 m/s. After the sample broke, the absorption work of the pendulum impact tester was read. Finally, the pendulum impact strength was calculated.
6) Drop hammer impact toughness: using the drop hammer impact tester. The drop hammer of the impact tester had a drop height of 100cm and a weight of 1Kg. Toughness evaluation: the clearer the cross was, the better the toughness of the product was, represented by the character ⊚ If the cross was blurred, it showed that the product had poor toughness and brittleness, which was represented by the character △. If the clarity of the cross was between clarity and blur, it indicated that the product had a general toughness, which was represented by the character O.
7) PCT: After etching the copper foil on the surface of the copper clad plate, the substrate was placed in a pressure cooker, treated at 120°C and 150 KPa for two hours, and then immersed in a tin furnace at 288°C. When the substrate was layered, the corresponding time was recorded. The evaluation could be ended if bubbles or delamination did not appear after the substrate was in the tin furnace for more than 5 minutes.

### Physical property analysis

It can be seen from the physical property data in Tables 2 and 3 that Comparison Example 1 discloses that the substrate has a higher glass transition temperature, better electrical properties, lower water absorption ratio, but extremely worst toughness after the polyfunctional vinyl aromatic copolymer VOD-A was used for self-curing. In Comparison Example 3, after the addition of the hydrogenated styrene butadiene block copolymer, the toughness of the substrate was improved, but the glass transition temperature was significantly reduced. Moreover, the delamination and plate blasting appeared, and it had a poor heat and humidity resistance. In Comparison Example 4, the terminal (meth)acryloyl cage-type silsesquioxane A was introduced as a crosslinking agent. It was inferior in dielectric properties due to its high polarity. In Comparison Example 5, the content of vinyl group added at 1,2-position in the polybutadiene used was less than 50%; the heat resistance of the substrate was remarkably lowered, and the PCT water absorption rate was increased. In Comparison Example 6, polybutadiene resin containing no 1,2-vinyl group was used; the heat resistance of the substrate was remarkably lowered; the PCT water absorption rate was increased; the dielectric properties were deteriorated; and the toughness was also lowered. In Examples 1 to 9, polybutadiene resin was used as the polyfunctional vinyl aromatic copolymer VOD-A or VOD-B. The cured substrate had good toughness and maintained its high glass transition temperature, low water absorption, excellent dielectric properties and heat and humidity resistance.

As described above, the circuit substrate of the present invention has good toughness as compared with general laminates, and maintains its high glass transition temperature, low water absorption, excellent dielectric properties, and moist heat resistance.

## Claims

1. A thermosetting resin composition, **characterized in that** the thermosetting resin composition comprises
component (A) a solvent-soluble polyfunctional vinyl aromatic copolymer having a structural unit derived from monomers comprising divinyl aromatic compound (a) and ethyl vinyl aromatic compound (b), comprising 20 mol.% or more of repeating units derived from divinyl aromatic compound (a), wherein the molar fraction of the vinyl group-containing structural unit derived from the divinyl aromatic compound (a) represented by the following formulae (a1) and (a2) satisfies (a1)/[(a1)+(a2)]≥0.5; the polystyrene-equivalent number average molecular weight Mn measured by gel permeation chromatography is 600 to 30,000; and the ratio of the weight average molecular weight Mw to the number average molecular weight Mn is 20.0 or less, 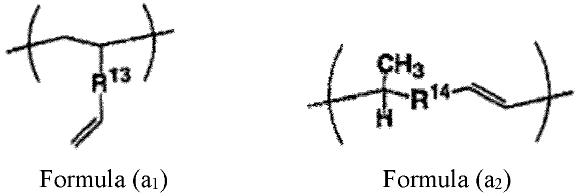 wherein R₁₃ represents an aromatic hydrocarbon group having 6 to 30 carbon atoms; R₁₄ represents an aromatic hydrocarbon group having 6 to 30 carbon atoms;
and
component (B) which is selected from polybutadiene resins having a number average molecular weight of 500-10,000, wherein the content of vinyl groups added at the 1,2 position in the molecular of the polybutadiene resins is 50% or more.

2. The thermosetting resin composition according to claim 1, **characterized in that**, in the thermosetting resin composition, the compounding amount of the component (A) is 10 to 98 wt.%, and the compounding amount of the component (B) is 2 to 90 wt.% based on the total weight of the components (A) and (B).

3. The thermosetting resin composition according to claim 1, **characterized in that**, the main chain skeleton of the soluble polyfunctional vinyl aromatic copolymer has an indane structure represented by the following formula (a₃) 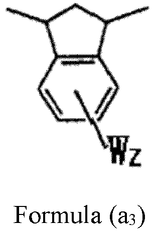 wherein W represents a saturated or unsaturated aliphatic hydrocarbon group or an aromatic hydrocarbon group, or an aromatic ring or a substituted aromatic ring fused to a benzene ring; Z is an integer of 0 to 4.

4. The thermosetting resin composition according to claim 1, **characterized in that**, the soluble polyfunctional vinyl aromatic copolymer has a metal ion content, *i.e.* the total content of various metal ions, of less than or equivalent to 500ppm.

5. The thermosetting resin composition according to claim 1 or 2, **characterized in that** the component (A) is a soluble polyfunctional vinyl aromatic copolymer containing a structural unit of monovinyl aromatic compounds (c) other than the ethyl vinyl aromatic compounds (b).

6. The thermosetting resin composition according to any of claims 1-5, **characterized in that** there further contains an initiator as the component (C) in addition to the components (A) and (B); the component (C) is used in an amount of 0.1 to 10 by weight, based on 100 parts by weight of the component (A) and the component (B).

7. The thermosetting resin composition according to claim 6, **characterized in that** the component (C) initiator has a half-life temperature t_{1/2} of not less than 130°C; the initiator is a radical initiator.

8. The thermosetting resin composition according to claim 6, **characterized in that** the initiator is selected from the group consisting of dicumyl peroxide, tert-butyl peroxybenzoate, 2,5-bis(2-ethylhexanoylperoxy)-2,5-dimethylhexane, di-(tert-butylperoxy-iso- propyl)benzene, 2,4-dichlorobenzoyl peroxide, 2,5-dimethyl-2,5-bis(tert-butylperoxy)hexane, tert-butyl-2-ethylhexyl peroxycarbonate, 2,5-dimethyl-2,5-bis(tert-butylperoxy)-3-hexyne, 4,4-di (tert-butyl-peroxy)butyl valerate, 1,1-bis(tert-butylperoxy)-3,3,5-trimethylcyclohexane, 3,3,5,7,7-pentamethyl-1,2,4-trioxepane, di-tert-butyl peroxide or t-butylperoxybenzene, or a combination of at least two selected therefrom.

9. The thermosetting resin composition according to claim 1, **characterized in that** the thermosetting resin composition further comprises a filler, wherein the filler comprises an organic filler and/or an inorganic filler.

10. The thermosetting resin composition according to claim 9, **characterized in that** the inorganic filler is selected from the group consisting of crystalline silica, fused silica, spherical silica, hollow silica, glass frit, aluminum nitride, boron nitride, silicon carbide, silicon aluminum silicate, hydrogen hydroxide aluminum, magnesium hydroxide, titanium dioxide, barium titanate, barium titanate, zinc oxide, zirconium oxide, aluminum oxide, barium oxide, magnesium oxide, barium sulfate, talc, clay, calcium silicate, calcium carbonate and mica, or a combination of at least two selected therefrom;
the organic filler is selected from the group consisting of polytetrafluoroethylene powder, polyphenylene sulfide, polyetherimide, polyphenylene ether and polyethersulfone powder, or a combination of at least two selected therefrom.

11. The thermosetting resin composition according to claim 1, **characterized in that**, the thermosetting resin composition further comprises a flame retardant, wherein the flame retardant may be a bromine-containing flame retardant or a halogen-free flame retardant.

12. The thermosetting resin composition according to claim 11, **characterized in that**, the bromine-containing flame retardant is selected from the group consisting of decabromodiphenyl ether, decabromodiphenylethane, ethylene bistetrabromophthalimide and brominated polycarbonate, or a combination of at least two selected therefrom;
the halogen-free flame retardant is selected from the group consisting of phosphorus-containing halogen-free flame retardants, nitrogen-containing halogen-free flame retardants and silicon-containing halogen-free flame retardants, or a combination of at least two selected therefrom.

13. The thermosetting resin composition according to claim 11, **characterized in that** the halogen-free flame retardant is selected from the group consisting of tris(2,6-dimethylphenyl)phosphine, 10-(2,5-dihydroxyphenyl)-9,10-dihydro-9-oxa-10-phospha-phenanthrene-10-oxide, 2,6-bis(2,6-dimethylphenyl)phosphinobenzene and 10-phenyl-9,10-dihydro-9-oxa-10-phosphaphenanthrene-10-oxide, phenoxyphosphine cyanide compound, phosphate and polyphosphate, or a combination of at least two selected therefrom.

14. The thermosetting resin composition according to claim 11, **characterized in that**, the flame retardant is used in an amount of 5 to 80 parts by weight, based on 100 parts by weight of the component (A) + component (B).

15. A resin varnish, **characterized in that** it is obtained by dissolving or dispersing the thermosetting resin composition in any of claims 1-14 in a solvent.

16. A prepreg, **characterized in that** the prepreg comprises a substrate and the thermosetting resin composition in any of claims 1-14 adhered to the substrate by impregnation and drying.

17. A laminate, **characterized in that** the laminate comprises at least one prepreg according to claim 16.

18. A metal foil-clad laminate, comprising one or at least two laminated prepregs according to claim 16, and metal foils on one side or both sides of the laminated prepreg.

19. A high-frequency high-speed circuit board comprising one or at least two laminated prepregs according to claim 16.

## Patentansprüche

1. Duroplastzusammensetzung, **dadurch gekennzeichnet, dass** die Duroplastzusammensetzung umfasst:
Komponente (A), ein lösungsmittellösliches polyfunktionelles aromatisches Vinyl-Copolymer mit einer Struktureinheit, die von Monomeren abgeleitet ist, die eine aromatische Divinylverbindung (a) und eine aromatische Ethylvinylverbindung (b) umfassen, umfassend 20 Mol.-% oder mehr an sich wiederholenden Einheiten, die von der aromatischen Divinylverbindung (a) abgeleitet sind, wobei der molare Anteil der Vinylgruppenenthaltenden Struktureinheit, die von der aromatischen Divinylverbindung (a) abgeleitet ist und durch die folgenden Formeln (a1) und (a2) dargestellt wird, (a1)/[(a1)+(a2)]≥0,5 erfüllt; das Polystyrol-äquivalente zahlenmittlere Molekulargewicht Mn, gemessen durch Gelpermeationschromatographie, 600 bis 30.000 beträgt; und das Verhältnis des gewichtsmittleren Molekulargewichts Mw zu dem zahlenmittleren Molekulargewicht Mn 20,0 oder weniger beträgt, 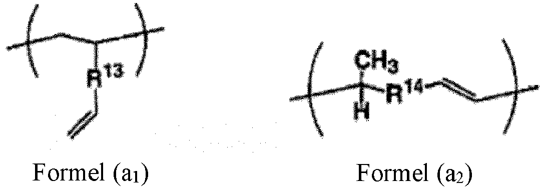
wobei R₁₃ eine aromatische Kohlenwasserstoffgruppe mit 6 bis 30 Kohlenstoffatomen darstellt; R₁₄ eine aromatische Kohlenwasserstoffgruppe mit 6 bis 30 Kohlenstoffatomen darstellt;
und
Komponente (B), die aus Polybutadienharzen mit einem zahlenmittleren Molekulargewicht von 500-10.000 ausgewählt ist, wobei der Gehalt an Vinylgruppen, die an der 1,2-Position in dem Molekül der Polybutadienharze hinzugefügt sind, 50 % oder mehr beträgt.

2. Duroplastzusammensetzung nach Anspruch 1, **dadurch gekennzeichnet, dass** in der wärmehärtenden Harzzusammensetzung die Compoundiermenge der Komponente (A) 10 bis 98 Gew.-% beträgt und die Compoundiermenge der Komponente (B) 2 bis 90 Gew.-%, bezogen auf das Gesamtgewicht der Komponenten (A) und (B), beträgt.

3. Duroplastzusammensetzung nach Anspruch 1, **dadurch gekennzeichnet, dass** das Hauptkettengerüst des löslichen polyfunktionellen aromatischen Vinyl-Copolymers eine Indanstruktur aufweist, die durch die folgende Formel (a₃) dargestellt wird 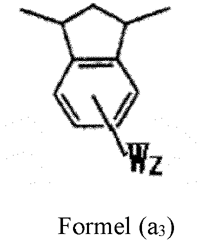 wobei W eine gesättigte oder ungesättigte aliphatische Kohlenwasserstoffgruppe oder eine aromatische Kohlenwasserstoffgruppe oder einen aromatischen Ring oder einen substituierten aromatischen Ring, der an einen Benzolring kondensiert ist, darstellt; Z eine ganze Zahl von 0 bis 4 ist.

4. Duroplastzusammensetzung nach Anspruch 1, **dadurch gekennzeichnet, dass** das lösliche polyfunktionelle aromatische Vinyl-Copolymer einen Metallionengehalt, *d. h.* den Gesamtgehalt an verschiedenen Metallionen, von weniger als oder gleich 500 ppm aufweist.

5. Duroplastzusammensetzung nach Anspruch 1 oder 2, **dadurch gekennzeichnet, dass** die Komponente (A) ein lösliches polyfunktionelles aromatisches Vinyl-Copolymer ist, das eine Struktureinheit aus aromatischen Monovinyl-Verbindungen (c) enthält, die von den aromatischen Ethylvinylverbindungen (b) verschieden ist.

6. Duroplastzusammensetzung nach einem der Ansprüche 1-5, **dadurch gekennzeichnet, dass** sie ferner einen Initiator als die Komponente (C) zusätzlich zu den Komponenten (A) und (B) enthält; die Komponente (C) in einer Menge von 0,1 bis 10 Gewichtsteilen, bezogen auf 100 Gewichtsteile der Komponente (A) und der Komponente (B), verwendet wird.

7. Duroplastzusammensetzung nach Anspruch 6, **dadurch gekennzeichnet, dass** der Initiator der Komponente (C) eine Halbwertszeittemperatur t_{1/2} von nicht weniger als 130 °C aufweist; der Initiator ein Radikalinitiator ist.

8. Duroplastzusammensetzung nach Anspruch 6, **dadurch gekennzeichnet, dass** der Initiator aus der Gruppe ausgewählt ist, bestehend aus Dicumylperoxid, tert-Butylperoxybenzoat, 2,5-Bis(2-ethylhexanoylperoxy)-2,5-dimethylhexan, Di-(tert-butylperoxy-iso-propyl)benzol, 2,4-Dichlorbenzoylperoxid, 2,5-Dimethyl-2,5-bis(tert-butylperoxy)hexan, tert-Butyl-2-ethylhexylperoxycarbonat, 2,5-Dimethyl-2,5-bis(tert-butylperoxy)-3-hexan, 4,4-Di(tert-butyl-peroxy)butylvalerat, 1,1-Bis(tert-butylperoxy)-3,3,5-trimethylcyclohexan, 3,3,5,7,7-Pentamethyl-1,2,4-trioxepan, Di-tert-butylperoxid oder t-Butylperoxybenzol, oder einer Kombination aus wenigstens zwei daraus ausgewählten.

9. Duroplastzusammensetzung nach Anspruch 1, **dadurch gekennzeichnet, dass** die Duroplastzusammensetzung ferner einen Füllstoff umfasst, wobei der Füllstoff einen organischen Füllstoff und/oder einen anorganischen Füllstoff umfasst.

10. Duroplastzusammensetzung nach Anspruch 9, **dadurch gekennzeichnet, dass** der anorganische Füllstoff aus der Gruppe ausgewählt ist, bestehend aus kristallinem Siliciumdioxid, kondensiertem Siliciumdioxid, sphärischem Siliciumdioxid, hohlem Siliciumdioxid, Glasfritte, Aluminiumnitrid, Bornitrid, Siliciumcarbid, Siliciumaluminiumsilicat, Wasserstoffhydroxidaluminium, Magnesiumhydroxid, Titandioxid, Bariumtitanat, Bariumtitanat, Zinkoxid, Zirconiumoxid, Aluminiumoxid, Bariumoxid, Magnesiumoxid, Bariumsulfat, Talk, Ton, Calciumsilicat, Calciumcarbonat und Glimmer oder eine Kombination von wenigstens zwei daraus ausgewählten;
der organische Füllstoff aus der Gruppe ausgewählt ist, bestehend aus Polytetrafluorethylenpulver, Polyphenylensulfid-, Polyetherimid-, Polyphenylenether- und Polyethersulfonpulver oder einer Kombination von wenigstens zwei daraus ausgewählten.

11. Duroplastzusammensetzung nach Anspruch 1, **dadurch gekennzeichnet, dass** die Duroplastzusammensetzung ferner ein Flammschutzmittel umfasst, wobei das Flammschutzmittel ein bromhaltiges Flammschutzmittel oder ein halogenfreies Flammschutzmittel sein kann.

12. Duroplastzusammensetzung nach Anspruch 11, **dadurch gekennzeichnet, dass** das bromhaltige Flammschutzmittel aus der Gruppe ausgewählt ist, bestehend aus Decabromdiphenylether, Decabromdiphenylethan, Ethylenbistetrabromphthalimid und bromiertem Polycarbonat oder einer Kombination von wenigstens zwei daraus ausgewählten;
das halogenfreie Flammschutzmittel aus der Gruppe ausgewählt ist, bestehend aus phosphorhaltigen halogenfreien Flammschutzmitteln, stickstoffhaltigen halogenfreien Flammschutzmitteln und siliciumhaltigen halogenfreien Flammschutzmitteln oder einer Kombination von wenigstens zwei daraus ausgewählten.

13. Duroplastzusammensetzung nach Anspruch 11, **dadurch gekennzeichnet, dass** das halogenfreie Flammschutzmittel aus der Gruppe ausgewählt ist, bestehend aus Tris(2,6-dimethylphenyl)phosphin, 10-(2,5-Dihydroxyphenyl)-9,10-dihydro-9-oxa-10-phospha-phenanthren-10-oxid, 2,6-Bis(2,6-dimethylphenyl)phosphinobenzol und 10-Phenyl-9,10-dihydro-9-oxa-10-phosphaphenanthren-10-oxid, Phenoxyphosphincyanidverbindung, Phosphat und Polyphosphat oder einer Kombination von wenigstens zwei daraus ausgewählten.

14. Duroplastzusammensetzung nach Anspruch 11, **dadurch gekennzeichnet, dass** das Flammschutzmittel in einer Menge von 5 bis 80 Gewichtsteilen, bezogen auf 100 Gewichtsteile der Komponente (A) + Komponente (B), verwendet wird.

15. Tränkharz, **dadurch gekennzeichnet, dass** es durch Lösen oder Dispergieren der Duroplastzusammensetzung nach einem der Ansprüche 1-14 in einem Lösungsmittel erhalten wird.

16. Prepreg, **dadurch gekennzeichnet, dass** das Prepreg ein Substrat und die Duroplastzusammensetzung nach einem der Ansprüche 1-14 umfasst, die durch Imprägnieren und Trocknen an dem Substrat haftet.

17. Laminat, **dadurch gekennzeichnet, dass** das Laminat wenigstens ein Prepreg nach Anspruch 16 umfasst.

18. Metallfolienplattiertes Laminat, umfassend ein oder wenigstens zwei laminierte Prepregs nach Anspruch 16 und Metallfolien auf einer Seite oder beiden Seiten des laminierten Prepregs.

19. Hochfrequenz-Hochgeschwindigkeitsleiterplatte, umfassend ein oder wenigstens zwei laminierte Prepregs nach Anspruch 16.

## Revendications

1. Composition de résine thermodurcissable, **caractérisée en ce que** la composition de résine thermodurcissable comprend
un composant (A) qui est un copolymère aromatique de vinyle polyfonctionnel soluble dans un solvant ayant une unité structurale dérivée de monomères comprenant un composé aromatique divinylique (a) et un composé aromatique de vinyle éthylique (b), comprenant 20 % en moles ou plus d'unités de répétition dérivées du composé aromatique divinylique (a), dans laquelle la fraction molaire de l'unité structurale contenant un groupe vinyle dérivée du composé aromatique divinylique (a) représenté par les formules ci-après (a1) et (a2) satisfait à (a1)/[(a1)+(a2)]≥0,5 ; le poids moléculaire moyen en nombre équivalent Mn du polystyrène mesuré par chromatographie par perméation de gel est compris entre 600 et 30 000 ; et le rapport de la masse moléculaire moyenne en poids Mw au poids moléculaire moyen en nombre Mn est égal ou inférieur à 20,0, 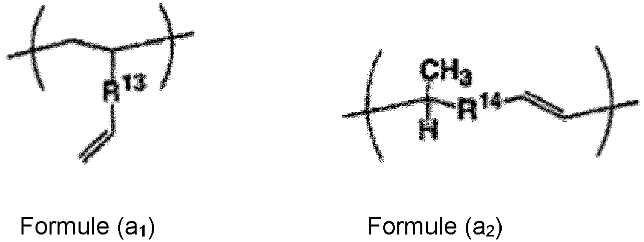
dans laquelle R₁₃ représente un groupe hydrocarboné aromatique ayant 6 à 30 atomes de carbone ; R₁₄ représente un groupe hydrocarboné aromatique ayant 6 à 30 atomes de carbone ; et
un composant (B) qui est sélectionné parmi des résines de polybutadiène ayant un poids moléculaire moyen en nombre compris entre 500 et 10 000, dans laquelle la teneur en groupes vinyle ajoutés à la position 1,2 dans le poids moléculaire des résines de polybutadiène est égale ou supérieure à 50 %.

2. Composition de résine thermodurcissable selon la revendication 1, **caractérisée en ce que**, dans la composition de résine thermodurcissable, la quantité combinée du composant (A) est comprise entre 10 et 98 % en poids et la quantité combinée du composant (B) est comprise entre 2 et 90 % en poids sur la base du poids total des composants (A) et (B).

3. Composition de résine thermodurcissable selon la revendication 1, **caractérisée en ce que** le squelette de chaîne principale du copolymère aromatique de vinyle polyfonctionnel soluble a une structure indane représentée par la formule ci-après (a₃) 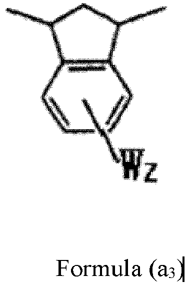 dans laquelle W représente un groupe hydrocarboné aliphatique saturé ou insaturé ou un groupe hydrocarboné aromatique ou un cycle aromatique ou un cycle aromatique substitué fusionné à un cycle de benzène ; Z est un nombre entier de 0 à 4.

4. Composition de résine thermodurcissable selon la revendication 1, **caractérisée en ce que** le copolymère aromatique de vinyle polyfonctionnel soluble a une teneur en ions métalliques, c'est-à-dire la teneur totale en divers ions métalliques, inférieure à ou équivalente à 500 ppm.

5. Composition de résine thermodurcissable selon la revendication 1 ou 2, **caractérisée en ce que** le composant (A) est un copolymère aromatique de vinyle polyfonctionnel soluble contenant une unité structurale de composés aromatiques monovinyles (c) autres que les composés aromatiques de vinyle éthylique (b).

6. Composition de résine thermodurcissable selon l'une quelconque des revendications 1-5, **caractérisée en ce qu'**elle contient en outre un initiateur en tant que composant (C) en plus des composants (A) et (B) ; le composant (C) est utilisé dans une quantité comprise entre 0,1 et 10 en poids sur la base de 100 parties en poids du composant (A) et du composant (B).

7. Composition de résine thermodurcissable selon la revendication 6, **caractérisée en ce que** l'initiateur du composant (C) a une température de demi-vie t_{1/2} qui n'est pas inférieure à 130°C ; l'initiateur est un initiateur radical.

8. Composition de résine thermodurcissable selon la revendication 6, **caractérisée en ce que** l'initiateur est sélectionné dans le groupe constitué de peroxyde de dicumyle, peroxybenzoate de tert-butyle, 2,5-bis(2-éthylhexanoylperoxy)-2,5-diméthylhexane, di-(tert-butylpéroxy-iso-propyl)benzène, peroxyde de 2,4-dichlorobenzoyle, 2,5-diméthy1-2,5-bis(tert-butylperoxy)hexane, peroxycarbonate de tert-butyl-2-éthylhexyl, 2,5-diméthyl-2,5-bis(tert-butylperoxy)-3-hexyne, valérate de 4,4-di(tert-butyl-peroxy)butyl, 1,1-bis(tert-butylperoxy)-3,3,5-triméthylcyclohexane, 3,3,5,7,7-pentaméthyl-1,2,4-trioxepane, peroxyde de di-tert-butyle ou t-butylperoxybenzène, ou une combination d'au moins deux éléments sélectionnés parmi ces derniers.

9. Composition de résine thermodurcissable selon la revendication 1, **caractérisée en ce que** la composition de résine thermodurcissable comprend en outre une charge, dans laquelle la charge comprend une charge organique et/ou une charge inorganique.

10. Composition de résine thermodurcissable selon la revendication 9, **caractérisée en ce que** la charge inorganique est sélectionnée dans le groupe constitué de silice cristalline, silice fondue, silice sphérique, silice creuse, fritte de verre, nitrure d'aluminium, nitrure de bore, carbure de silicium, silicate d'aluminium silicium, hydroxyde d'aluminium hydrogène, hydroxyde de magnésium, dioxyde de titane, titanate de baryum, oxyde de zinc, oxyde de zirconium, oxyde d'aluminium, oxyde de baryum, oxyde de magnésium, sulfate de baryum, talc, argile, silicate de calcium, carbonate de calcium et mica, ou une combinaison d'au moins deux éléments sélectionnés parmi ces derniers ;
la charge organique est sélectionnée dans le groupe constitué de poudre de polytétrafluoroéthylène, sulfure de polyphénylène, polyétherimide, éther de polyphénylène et poudre de polyéthersulfone, ou une combinaison d'au moins deux éléments sélectionnés parmi ces derniers.

11. Composition de résine thermodurcissable selon la revendication 1, **caractérisée en ce que** la composition de résine thermodurcissable comprend en outre un retardateur de flamme, dans laquelle le retardateur de flamme peut être un retardateur de flamme contenant du brome ou un retardateur de flamme sans halogène.

12. Composition de résine thermodurcissable selon la revendication 11, **caractérisée en ce que**, le retardateur de flamme contenant du brome est sélectionné dans le groupe constitué d'éther de décabromodiphényle, décabromodiphényléthane, bistétrabromophtalimide d'éthylène et polycarbonate bromé, ou une combinaison d'au moins deux éléments sélectionnés parmi ces derniers ;
le retardateur de flamme sans halogène est sélectionné dans le groupe constitué de retardateurs de flamme sans halogène contenant du phosphore, retardateurs de flamme sans halogène contenant de l'azote et retardateurs de flamme sans halogène contenant du silicium, ou une combinaison d'au moins deux éléments sélectionnés parmi ces derniers.

13. Composition de résine thermodurcissable selon la revendication 11, **caractérisée en ce que** le retardateur de flamme sans halogène est sélectionné dans le groupe constitué de tris(2,6-diméthylphényl)phosphine, 10-(2,5-dihydroxyphényl)-9,10-dihydro-9-oxa-10-phospha-phénanthrène-10-oxyde, 2,6-bis(2,6-diméthylphényl)phosphinobenzène et 10-phényl-9,10-dihydro-9-oxa-10-phosphaphénanthrène-10-oxyde, composé de cyanure de phénoxyphosphine, phosphate et polyphosphate, ou une combinaison d'au moins deux éléments sélectionnés parmi ces derniers.

14. Composition de résine thermodurcissable selon la revendication 11, **caractérisée en ce que** le retardateur de flamme est utilisé dans une quantité comprise entre 5 et 80 parties en poids, sur la base de 100 parties en poids du composant (A) et du composant (B).

15. Vernis de résine, **caractérisé en ce qu'**il est obtenu en dissolvant ou dispersant la composition de résine thermodurcissable selon l'une quelconque des revendications 1 à 14 dans un solvant.

16. Préimprégné, **caractérisé en ce que** le préimprégné comprend un substrat et la composition de résine thermodurcissable selon l'une quelconque des revendications 1 à 14, adhéré au substrat par imprégnation et séchage.

17. Stratifié, **caractérisé en ce que** le stratifié comprend au moins un préimprégné selon la revendication 16.

18. Stratifié revêtue de feuille métallique, comprenant un ou au moins deux préimprégnés stratifiés selon la revendication 16, et des feuilles métalliques d'un côté ou des deux côtés du préimprégné stratifié.

19. Carte de circuit imprimé haute vitesse à haute fréquence comprenant un ou au moins deux préimprégnés stratifiés selon la revendication 16.
